# EUROPEAN PATENT APPLICATION

(11) **EP 2 230 327 A1**
(43) Date of publication of application: **22.09.2010**
(21) Application number: 09015968.2
(22) Date of filing: 23.12.2009
(51) Int. Cl.: C23C 16/27

(54) **Diamond coating for cutting tool**

(30) Priority: 23.02.2009 JP 2009039535
(71) Applicant: UNION TOOL CO., Shinagawa-ku Tokyo (JP)
(72) Inventor: Sato, Akira, Shinagawa-ku Tokyo (JP); Watanabe, Yuji, Shinagawa-ku Tokyo (JP); Hagino, Kenji, Shinagawa-ku Tokyo (JP); Sato, Kazutaka, Shinagawa-ku Tokyo (JP)
(74) Representative: Kramer - Barske - Schmidtchen

(57) **Abstract**

There is provided an extremely practical diamond coating for a cutting tool that has excellent adhesion to a cemented carbide base metal, high hardness and adequate abrasion resistance with respect to a nonferrous high-hardness work material, and the ability to significantly extend the service life of a cutting tool. The diamond coating for a cutting tool is formed on a substrate, wherein the diamond coating for a cutting tool is configured so that the diamond coating includes at least one or more layers of a multilayer coating layer in which one or more layers of each of a first coating layer having an average crystal particle diameter of 0.3 3 µm or greater and 3 µm or less and a second coating layer having a larger average crystal particle diameter than the first coating layer are layered in alternating fashion, and the first coating layer is formed having a film thickness of 1 µm or greater and 10 µm or less directly on the substrate.

## Description

### FIELD OF THE INVENTION

The present invention relates to a diamond coating for a cutting tool to be used for coating a tool used in cutting and other machining of a nonferrous work material having a high degree of hardness.

### BACKGROUND OF THE INVENTION

Cutting tools in which a cemented carbide base metal is coated by a hard film of TiN, TiAlN, or the like in order to enhance the abrasion resistance of the cemented carbide cutting tool have recently come to be used.

Cutting tools in which a diamond coating is applied to a cemented carbide base metal using CDV have also recently come into use for machining hard carbon, Si-containing aluminum alloys, and other nonferrous high-hardness work materials (see Patent Document 1).

[Patent Document 1] Japanese Laid-open Patent Publication No. 2003-25117

However, the adhesion between the diamond coating and the cemented carbide base metal is not necessarily high, and the coating easily peels off during cutting. A graphite component is also present along with the pure diamond component in the conventional diamond coating, and since the graphite component portion is not as hard as the pure diamond portion, the graphite component portion does not necessarily exhibit adequate abrasion resistance with respect to nonferrous high-hardness work materials.

### SUMMARY OF THE INVENTION

As a result of investigating the coating structure and coating layer makeup of a diamond coating in view of such problems as those described above, the inventors developed the present invention upon discovering that the problems described above can be overcome by designing an improved coating structure and coating makeup, and the present invention provides an extremely practical diamond coating for a cutting tool that has excellent adhesion to a cemented carbide base metal, high hardness and adequate abrasion resistance with respect to a nonferrous high-hardness work material, and the ability to significantly extend the service life of a cutting tool.

The present invention is summarized below.

A first aspect of the present invention is a diamond coating for a cutting tool, formed on a substrate, the diamond coating for a cutting tool **characterized in that** the diamond coating includes at least one or more layers of a multilayer coating layer in which one or more layers of each of a first coating layer having an average crystal particle diameter of 0.3 µm or greater and 3 µm or less and a second coating layer having a larger average crystal particle diameter than the first coating layer are layered in alternating fashion, and the first coating layer is formed having a film thickness of 1 µm or greater and 10 µm or less directly on the substrate.

In the diamond coating for a cutting tool according to the first aspect, the diamond coating for a cutting tool is **characterized in that** when the first coating layer and the second coating layer are subjected to Raman spectroscopy using laser light at a wavelength of 532 nm, the ratio [I_{D}/I_{G}] of the peak intensity I_{D} in the vicinity of a Raman shift of 1333 cm⁻¹ and the peak intensity I_{G} in the vicinity of a Raman shift of 1450 to 1600 cm⁻¹ for the first coating layer is in the range of 0.9 to 1.5, and (I_{D}/I_{G}] for the second coating layer is larger than [I_{D}/I_{G}] for the first coating layer.

In the diamond coating for a cutting tool according to the first aspect, the diamond coating for a cutting tool is **characterized in that** a third coating layer having a film thickness of 0.5 µm or greater and 10 µm or less is formed on an outermost layer, and the average crystal particle diameter of the third coating layer is smaller than the average crystal particle diameter of the first coating layer.

In the diamond coating for a cutting tool according to the second aspect, the diamond coating for a cutting tool is **characterized in that** a third coating layer having a film thickness of 0.5 µm or greater and 10 µm or less is formed on an outermost layer, and the average crystal particle diameter of the third coating layer is smaller than the average crystal particle diameter of the first coating layer.

In the diamond coating for a cutting tool according to the third aspect, the diamond coating for a cutting tool is **characterized in that** when the first coating layer and the third coating layer are subjected to Raman spectroscopy using laser light at a wavelength of 532 nm, the ratio [I_{D}/I_{G}] of the peak intensity I_{D} in the vicinity of a Raman shift of 1333 cm⁻¹ and the peak intensity I_{G} in the vicinity of a Raman shift of 1450 to 1600 cm⁻¹ for the first coating layer is larger than [I_{D}/I_{G}] for the third coating layer.

In the diamond coating for a cutting tool according to the fourth aspect, the diamond coating for a cutting tool is **characterized in that** when the first coating layer and the third coating layer are subjected to Raman spectroscopy using laser light at a wavelength of 532 nm, the ratio [I_{D}/I_{G}] of the peak intensity I_{D} in the vicinity of a Raman shift of 1333 cm⁻¹ and the peak intensity I_{G} in the vicinity of a Raman shift of 1450 to 1600 cm⁻¹ for the first coating layer is larger than [I_{D}/I_{G}] for the third coating layer.

In the diamond coating for a cutting tool according to any of the first through sixth aspects, the diamond coating for a cutting tool is **characterized in that** the substrate is cemented carbide comprising hard particles having WC as a primary component, and a binding agent having Co as a primary component; the average particle diameter of the WC particles is set to from 0.3 µm to 3 µm; and the content ratio of the Co in terms of percent by weight is set to from 3 to 15%.

The present invention is configured as described above, and is therefore an extremely practical diamond coating for a cutting tool that has excellent adhesion to a cemented carbide base metal, high hardness and adequate abrasion resistance with respect to a nonferrous high-hardness work material, and the ability to significantly extend the service life of a cutting tool.

### BRIEF DESCRIPTION OF THE DRAWINGS

FIG. 1 is an enlarged photograph of a surface of the first coating layer of the present embodiment;
FIG. 2 is an enlarged photograph of a surface of the second coating layer of the present embodiment;
FIG. 3 is an enlarged photograph of a surface of the third coating layer of the present embodiment;

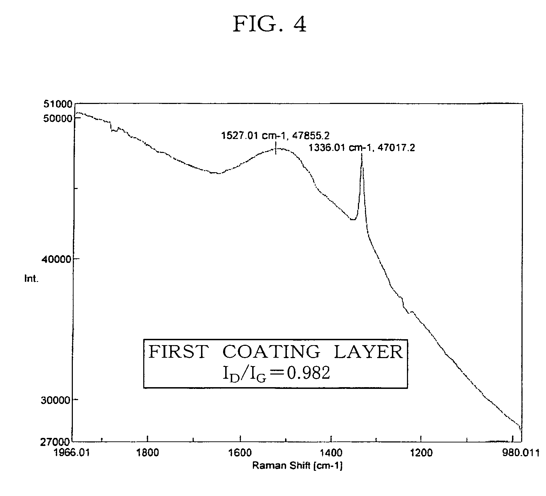

FIG. 4 shows the Raman spectrum of the first coating layer of the present embodiment;

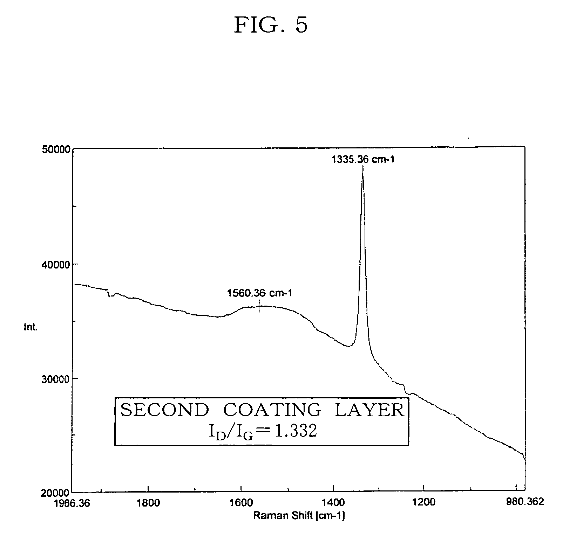

FIG. 5 shows the Raman spectrum of the second coating layer of the present embodiment;

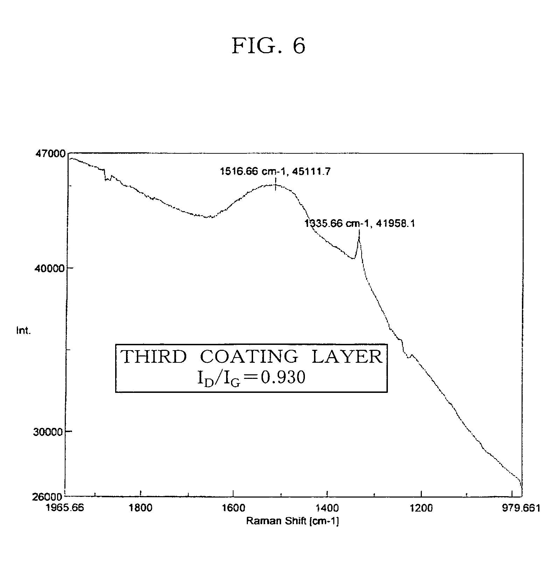

FIG. 6 shows the Raman spectrum of the third coating layer of the present embodiment;
FIG. 7 is a table showing the experimental results of Experimental Example 1; and
FIG. 8 is a table showing the experimental results of Experimental Example 2.

### BEST MODE FOR CARRYING OUT THE INVENTION

Preferred embodiments of the present invention will be briefly described by way of the operation of the present invention.

A nonferrous high-hardness work material, for example, is cut by a cutting tool on which a diamond coating is formed that includes a multilayer coating layer in which first coating layers and second coating layers are alternately layered.

In this instance, the first coating layer formed directly on the substrate has a predetermined average crystal particle diameter and film thickness, and thereby has excellent adhesion. At least one or more layers of a multilayer coating layer is included, in which a second coating layer having a larger average crystal particle diameter than the first coating layer is layered in alternating fashion with the first coating layer, and a high degree of hardness in comparison to that of a single-layer film of the first coating layer is thereby obtained.

The present invention is thereby not prone to peeling during cutting, abrasion resistance with respect to a nonferrous high-hardness work material is satisfactory, and the present invention is capable of significantly extending the service life of a cutting tool.

### Embodiments

Specific embodiments of the present invention will be described based on the drawings.

The present embodiment is a diamond coating for a cutting tool, the diamond coating being formed on a substrate, wherein the diamond coating includes at least one or more layers of a multilayer coating layer in which one or more layers of each of a first coating layer and a second coating layer having a larger average crystal particle diameter than the first coating layer are layered in alternating fashion, and the first coating layer of the multilayer coating layer is formed directly on the substrate.

Each component will be specifically described.

The substrate used in the present embodiment is a cemented carbide composed of hard particles having WC as a primary component, and a binding agent having Co as a primary component. The average particle diameter of the WC particles is set to from 0.3 µm to 3 µm, and the content ratio of the Co in terms of percent by weight is set to from 3 to 15%.

In the multilayer coating layer of the present embodiment, first coating layers and second coating layers are layered one at a time in alternating fashion. As described hereinafter, a diamond coating having more excellent hardness is obtained by layering a plurality of first coating layers and second coating layers in alternating fashion without changing the total thickness.

In the present embodiment, a third coating layer is provided to the outermost layer (outermost layer of the multilayer coating layer) of the diamond coating. The third coating layer is formed so that the average crystal particle diameter of the third coating layer is smaller than the average crystal particle diameter of the first coating layer.

Consequently, the average crystal particle diameter increases in the following sequence: third coating layer < first coating layer < second coating layer.

The average crystal particle diameter of the first coating layer may be set to 0.3 µm or greater and 3 µm or less.

According to the present application, the average crystal particle diameter is measured by using a method for measuring the maximum extension of each particle on an image taken by using a SEM (Scanning Electron Microscope), and calculating an average value of all values as measured to determine an average crystal particle value.

The reason for setting the average crystal particle diameter of the first coating layer and the average particle diameter of the WC particles of the cemented carbide to the abovementioned numerical ranges will first be described. As a result of research using diamond coatings having various average crystal particle diameters, and cemented carbides having various different average particle diameters of the WC particles, the inventors discovered that adhesion between the cemented carbide substrate and the diamond coating increases when the average crystal particle diameter of the diamond coating and the average diameter of the WC particles are close to each other. The inventors also learned that adhesion to the diamond coating is reduced when the average particle diameter of the WC particles of the cemented carbide is too large or too small, and that the preferred range for the average particle diameter is 0.3 µm or greater and 3 µm or less. Therefore, the average crystal particle diameter of the diamond coating is set to 0.3 µm or greater and 3 µm or less, in accordance with the average particle diameter of the WC particles of the cemented carbide. Further research is awaited as to the reasons that such results as those described above were obtained regarding the size of the WC particles of the cemented carbide or the relationship between the average crystal particle diameter of the diamond coating and the average particle diameter of the WC particles of the cemented carbide, but it is estimated that the surface area of the bond interface between the diamond coating and the cemented carbide is involved. Since adhesion is reduced when the film thickness of the first coating layer placed directly on the cemented carbide substrate is too low, the film thickness is preferably 1 µm or greater. Since the first coating layer placed directly on the cemented carbide substrate is formed for the purpose of ensuring adhesion, there is no need to make the first coating layer too thick, and a thickness of 10 µm or less is sufficient.

The reason for setting the average crystal particle diameter of the second coating layer in the abovementioned range will next be described. The inventors experimented with various different average crystal particle diameters for the diamond coating, and discovered that the hardness of the coating can be increased by increasing the size of the diamond crystal particles. A graphite component is usually present in addition to pure diamond in a diamond coating, and the hardness of the diamond coating begins to decrease when the ratio of the graphite component is high. The grain boundary surface area of the crystals decreases as the size of the diamond crystal particles increases. Since the graphite component is considered to easily become unevenly distributed at the crystal particle boundaries, it may be that reducing the surface area of the particle boundaries contributes to increasing the hardness of the coating. It is sufficient insofar as the average crystal particle diameter of the second coating layer is larger than the average crystal particle diameter of the first coating layer, but since the roughness of the coating layer boundaries or surface increases when the particle diameter is too large, it is more preferred that the average crystal particle diameter of the second coating layer be larger than the average crystal particle diameter of the first coating layer, specifically, 0.6 µm or greater and 6 µm or less.

The reason for setting the average crystal particle diameter of the third coating layer in the abovementioned range will next be described. The inventors experimented with various different average crystal particle diameters of the diamond coating, and confirmed that the roughness of the coating surface can be reduced by reducing the size of the diamond crystal particles. It is sufficient insofar as the average crystal particle diameter of the third coating layer is smaller than the average crystal particle diameter of the first coating layer, but since the hardness of the coating decreases when the particle diameter is too small, it is more preferred that the average crystal particle diameter of the third coating layer be smaller than the average crystal particle diameter of the first coating layer, specifically, 0.01 µm or greater and 0.5 µm or less. Since the effects whereby the roughness of the coating surface is reduced are diminished when the third coating layer is too thin, the thickness of the third coating layer is preferably 0.5 µm or greater. Since the average hardness of the coating (entire layered coating from the first coating layer directly on the substrate to the outermost layer) decreases when the third coating layer is too thick, the thickness of the third coating layer is preferably 10 µm or less.

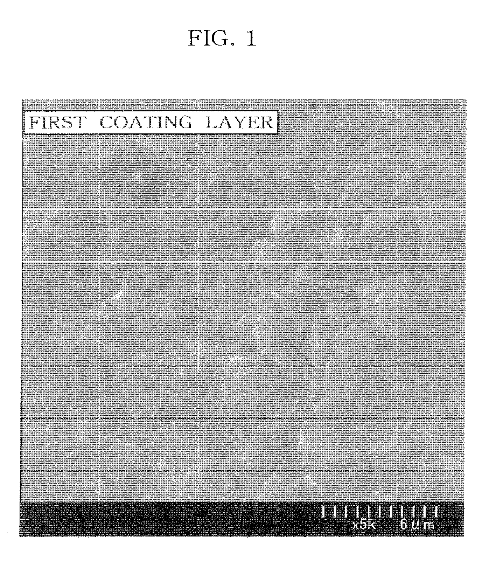

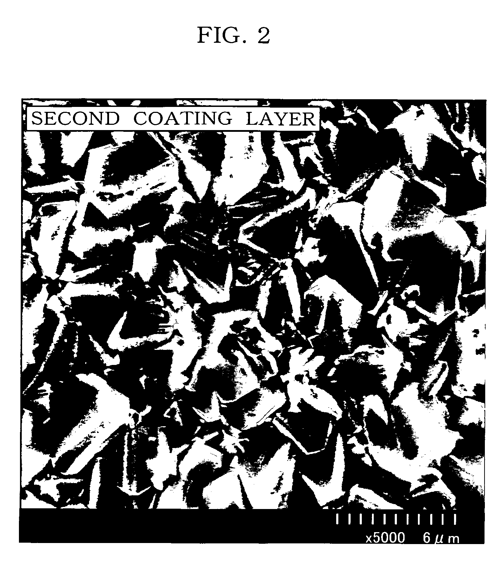

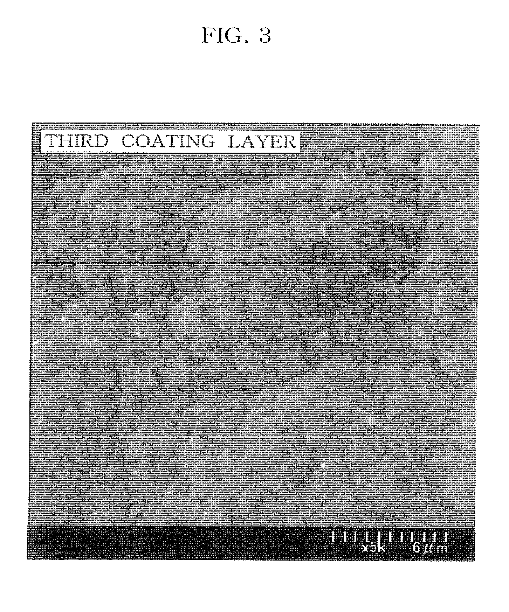

In the present embodiment, the average crystal particle diameter of the first coating layer is approximately 1.5 µm, the average crystal particle diameter of the second coating layer is approximately 3 µm, and the average crystal particle diameter of the third coating layer is approximately 0.1 µm, as shown in FIGS. 1 through 3.

The first coating layer, the second coating layer, and the third coating layer are formed by CVD (thermal CVD, for example) so that [I_{D}/I_{G}] of the second coating layer is larger than [I_{D}/I_{G}] of the first coating layer, and [I_{D}/I_{G}] of the first coating layer is larger than [I_{D}/I_{G}] of the third coating layer, [I_{D}/I_{G}] being the ratio of the peak intensity I_{D} in the vicinity of a Raman shift of 1333 cm⁻¹ and the peak intensity I_{G} in the vicinity of a Raman shift of 1450 to 1600 cm⁻¹, as computed from the Raman spectra obtained by subjecting the first coating layer, the second coating layer, and the third coating layer to Raman spectroscopy using laser light at a wavelength of 532 nm.

Consequently, [I_{D}/I_{G}] increases in the following sequence: third coating layer < first coating layer < second coating layer.

The peak in the vicinity of a Raman shift of 1333 cm⁻¹ is caused by the diamond component, and the peak in the vicinity of a Raman shift of 1450 to 1600 cm⁻¹ is caused by the graphite non-diamond component. A graphite component is usually present along with the pure diamond component in a diamond coating formed using CVD, and this means that the ratio of the pure diamond component in the coating is higher the larger the value of [I_{D}/I_{G}] is. Since the ratio of the pure diamond component is high when the value of [I_{D}/I_{G}] is large, the coating hardness increases, but when the ratio of the graphite component is too small, the bond strength between diamond crystal particles decreases, the toughness of the coating decreases, and the coating becomes brittle. The value of [I_{D}/I_{G}] of the first coating layer is set to the range of 0.9 to 1.5 in order to obtain a balance of hardness and toughness. Since the toughness of the second coating layer is ensured by layering with the first coating layer, increasing the hardness of the second coating layer is emphasized, and the value of [I_{D/}I_{G}] for the second coating layer is set higher than that of the first coating layer. However, due to concerns that cracking may occur in the second coating layer when the value of [I_{D}/I_{G}] is too large, it is more preferred that the value of [I_{D}/I_{G}] for the second coating layer be kept larger than that of the first coating layer and be set to a value of 5 or less. The third coating layer is a coating placed on the outermost layer, and therefore has a dominant effect on the toughness of the coating (the entire layered coating from the first coating layer directly on the substrate all the way to the outermost layer). Toughness is therefore emphasized over hardness, and the value of [I_{D}/I_{G}] is set lower than that of the first coating layer. However, since the ratio of the graphite component is too high and hardness decreases when the value of [I_{D}/I_{G}] is too low, the value of (I_{D}/I_{G}] for the third coating layer is more preferably kept lower than that of the first coating layer and is set to a value of 0.6 or higher.

In the present embodiment, the first coating layer constituting the multilayer coating layer is formed directly on the substrate, but this configuration of the first coating layer constituting the multilayer coating layer is not limiting, and a configuration may be adopted in which a first coating layer is separately formed directly on the substrate, and another coating layer is formed between the multilayer coating layer and the separately formed first coating layer.

Since the present embodiment is configured as described above, there is provided a cutting tool having a diamond coating in which a multilayer coating layer is formed by the alternate layering of a first coating layer and a second coating layer directly on a substrate, and forming a third coating layer on the outermost layer, whereby excellent adhesion and abrasion resistance can be demonstrated even when a nonferrous high-hardness work material is cut, and the service life of the cutting tool can be significantly extended.

The present embodiment is thus an extremely practical diamond coating for a cutting tool that has excellent adhesion to a cemented carbide base metal, high hardness and adequate abrasion resistance with respect to a nonferrous high-hardness work material, and the ability to significantly extend the service life of a cutting tool.

Experimental examples that support the effects of the present embodiment will next be described.

### [Experimental Example 1]

A first coating having the same composition as the abovementioned first coating layer, a second coating having the same composition as the abovementioned second coating layer, and a third coating having the same composition as the abovementioned third coating layer were each formed on a cemented carbide base metal (cemented carbide round bar having a diameter of 3 mm; average diameter of WC particles: 1 µm; Co content: 6 wt%) so as to have a thickness of 7 to 8 µm using a thermal filament-type CVD device with the base metal temperature set to from 650 to 750°C, while introducing H₂ gas, CH₄ gas, and O₂ gas to give a gas pressure of 500 Pa. The gas flow rate ratios in terms of H₂:CH₄:O₂ were 100:1:0 for the first coating, 100:1:1 for the second coating, and 100:3:1 for the third coating.

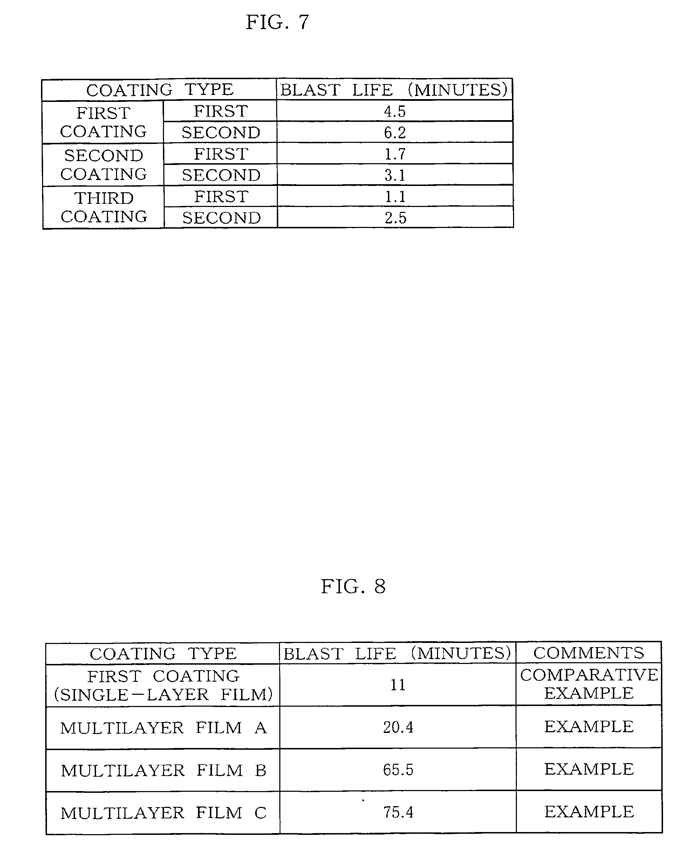

The blast life of each coating was then measured in order to make an overall evaluation of the hardness of each coating and the adhesion between the coating and the base metal. The results are shown in FIG. 7.

The blast life is the time until the coating directly under the nozzle is removed and the base metal appears during blast bombardment under the conditions described below. Under blast bombardment, the diamond coating is gradually removed, and the bombarded portion peels off, exposing the base metal when the coating thickness is reduced to a certain thickness. When adhesion between the coating and the base metal is low, the remaining coating peels off while still relatively thick, and when adhesion is high, the remaining coating does not peel off until the thickness thereof is relatively small.

### Blast conditions

Bombardment angle: perpendicular to the coating
Nozzle diameter: 0.8 mm
Abrasive: SiC #180
Air pressure: pressure at which a hole is formed through t3 soda lime glass in 20 seconds

As shown in FIG. 7, when the coating thickness was relatively small, being 7 to 8 µm, the first coating had the longest blast life. When the film thickness is small, since the adhesion of the coating and the base metal is the primary factor that affects the blast life (the degree to which the coating hardness affects the blast life increases when the film thickness is large), the results are considered to indicate that the first coating was most satisfactory in terms of adhesion between the coating and the base metal. It is therefore considered best to place the first coating directly on the base metal.

### [Experimental Example 2]

The cutting edge flank of an end mill was blast bombarded under the same conditions as in Experimental Example 1, and the blast life was measured for each of a multilayer film A, a multilayer film B, and a multilayer film C in which a first coating, a second coating, and a third coating were formed in the layering configurations described below to a total thickness of 11 to 12 µm on a cemented carbide base metal (two-flute square-type cemented carbide end mill having a diameter of 10 mm; average particle diameter of WC particles: 1 µm; Co content: 6 wt%) using a thermal filament-type CVD device, and the same base metal temperature, gas type, gas pressure, and gas flow rate ratios as in Experimental Example 1. The results are shown in FIG. 8. The "First coating (single-layer film)" portion of FIG. 8 shows the results of a comparative example in which only the first coating was formed to a thickness of 11 to 12 µm on the base metal under the same conditions as in Example 1.
Multilayer film A: base metal/first coating/second coating/third coating; (film thickness ratio: 1:2:2)
Multilayer film B: base metal/first coating/second coating/first coating/second coating; (film thickness ratio: 1:1:1:1)
Multilayer film C: base metal/first coating/second coating/first coating/second coating/third coating; (film thickness ratio: 8:7:6:7:12)

As shown in FIG. 8, it was confirmed that the multilayer films to which the second coating having a high ratio of the diamond component was added had a longer blast life than the first coating (single-layer film). Accordingly, it was confirmed that high hardness and satisfactory adhesion can be obtained at the same time by placing the first coating having excellent adhesion directly on the base metal, and adding the second coating.

A more satisfactory blast life than that of the multilayer film A in which one layer each of the first coating and second coating were alternately layered was obtained in the multilayer film B and the multilayer film C by alternately layering two layers each of the first coating and the second coating. The reason for this is considered to be that the second coating has a high ratio of the diamond component, and a high degree of hardness. However, the ratio of the graphite component is low, the bond strength between the diamond crystal particles is estimated to be relatively weak, and there is a risk of cracks occurring between the diamond crystal particles when the second coating is too thick. It is for this reason that the multilayer film B and multilayer film C in which a plurality of relatively thin layers of the second coating were provided had longer blast lives than the multilayer film A, in which only a single relatively thick layer of the second coating was provided.

It is explicitly stated that all features disclosed in the description and/or the claims are intended to be disclosed separately and independently from each other for the purpose of original disclosure as well as for the purpose of restricting the claimed invention independent of the composition of the features in the embodiments and/or the claims. It is explicitly stated that all value ranges or indications of groups of entities disclose every possible intermediate value or intermediate entity for the purpose of original disclosure as well as for the purpose of restricting the claimed invention, in particular as limits of value ranges.

## Claims

1. A diamond coating for a cutting tool, formed on a substrate, said diamond coating for a cutting tool **characterized in that** the diamond coating includes at least one or more layers of a multilayer coating layer in which one or more layers of each of a first coating layer having an average crystal particle diameter of 0.3 µm or greater and 3 µm or less and a second coating layer having a larger average crystal particle diameter than the first coating layer are layered in alternating fashion, and said first coating layer is formed having a film thickness of 1 µm or greater and 10 µm or less directly on said substrate.

2. The diamond coating for a cutting tool according to claim 1, said diamond coating for a cutting tool **characterized in that** when said first coating layer and said second coating layer are subjected to Raman spectroscopy using laser light at a wavelength of 532 nm, the ratio [I_{D}/I_{G}] of the peak intensity I_{D} in the vicinity of a Raman shift of 1333 cm⁻¹ and the peak intensity I_{G} in the vicinity of a Raman shift of 1450 to 1600 cm⁻¹ for the first coating layer is in the range of 0.9 to 1.5, and [I_{D}/I_{G}] for said second coating layer is larger than [I_{D}/I_{G}] for said first coating layer.

3. The diamond coating for a cutting tool according to claim 1, said diamond coating for a cutting tool **characterized in that** a third coating layer having a film thickness of 0.5 µm or greater and 10 µm or less is formed on an outermost layer, and the average crystal particle diameter of the third coating layer is smaller than the average crystal particle diameter of said first coating layer.

4. The diamond coating for a cutting tool according to claim 2, said diamond coating for a cutting tool **characterized in that** a third coating layer having a film thickness of 0.5 µm or greater and 10 µm or less is formed on an outermost layer, and the average crystal particle diameter of the third coating layer is smaller than the average crystal particle diameter of said first coating layer.

5. The diamond coating for a cutting tool according to claim 3, said diamond coating for a cutting tool **characterized in that** when said first coating layer and said third coating layer are subjected to Raman spectroscopy using laser light at a wavelength of 532 nm, the ratio [I_{D}/I_{G}] of the peak intensity I_{D} in the vicinity of a Raman shift of 1333 cm⁻¹ and the peak intensity I_{G} in the vicinity of a Raman shift of 1450 to 1600 cm⁻¹ for the first coating layer is larger than [I_{D}/I_{G}] for said third coating layer.

6. The diamond coating for a cutting tool according to claim 4, said diamond coating for a cutting tool **characterized in that** when said first coating layer and said third coating layer are subjected to Raman spectroscopy using laser light at a wavelength of 532 nm, the ratio [I_{D}/I_{G}] of the peak intensity I_{D} in the vicinity of a Raman shift of 1333 cm⁻¹ and the peak intensity I_{G} in the vicinity of a Raman shift of 1450 to 1600 cm⁻¹ for the first coating layer is larger than [I_{D}/I_{G}] for said third coating layer.

7. The diamond coating for a cutting tool according to any of claims 1 through 6, said diamond coating for a cutting tool **characterized in that** said substrate is cemented carbide comprising hard particles having WC as a primary component, and a binding agent having Co as a primary component; the average particle diameter of said WC particles is set to from 0.3 µm to 3 µm; and the content ratio of said Co in terms of percent by weight is set to from 3 to 15%.
